# EUROPEAN PATENT APPLICATION

(11) **EP 2 006 710 A2**
(43) Date of publication of application: **24.12.2008**
(21) Application number: 08010625.5
(22) Date of filing: 11.06.2008
(51) Int. Cl.: G01T 1/20, G01T 1/202

(54) **Radiation image conversion panel, scintillator panel, and radiation image sensor**

(30) Priority: 15.06.2007 US 812232
(71) Applicant: Hamamatsu Photonics K.K., Hamamatsu-shi, Shizuoka 435-8558 (JP)
(72) Inventor: Sakurai, Jun, Hamamatsu-shi Shizuoka 435-8558 (JP); Shimizu, Ichinobu, Hamamatsu-shi Shizuoka 435-8558 (JP); Kamimura, Gouji, Hamamatsu-shi Shizuoka 435-8558 (JP); Suzuki, Takaharu, Hamamatsu-shi Shizuoka 435-8558 (JP); Kusuyama, Yutaka, Hamamatsu-shi Shizuoka 435-8558 (JP); Shirakawa, Kazuhiro, Hamamatsu-shi Shizuoka 435-8558 (JP)
(74) Representative: Grünecker, Kinkeldey, Stockmair & Schwanhäusser Anwaltssozietät

(57) **Abstract**

The radiation image conversion panel in accordance with the present invention has an aluminum substrate, an alumite layer formed on a surface of the aluminum substrate, an intermediate film covering the alumite layer and having a radiation transparency and a light transparency, and a converting part provided on the intermediate film and adapted to convert a radiation image.

## Description

### BACKGROUND OF THE INVENTION

### Field of the Invention

The present invention relates to a radiation image conversion panel, a scintillator panel, and a radiation image sensor which are used in medical and industrial x-ray imaging and the like.

### Related Background Art

While x-ray sensitive films have conventionally been in use for medical and industrial x-ray imaging, radiation imaging systems using radiation detectors have been coming into widespread use from the viewpoint of their convenience and storability of imaging results. In such a radiation imaging system, pixel data formed by two-dimensional radiations are acquired by a radiation detector as an electric signal, which is then processed by a processor, so as to be displayed on a monitor.

Known as a typical radiation detector is one having a structure bonding a radiation image conversion panel (which will be referred to as "scintillator panel" in the following as the case may be), in which a scintillator for converting a radiation into visible light is formed on a substrate such as aluminum, glass, or fused silica, to an image pickup device. In this radiation detector, a radiation incident thereon from the substrate side is converted into light by the scintillator, and thus obtained light is detected by the image pickup device.

In the radiation image conversion panels disclosed in Japanese Patent Application Laid-Open Nos. 2006-113007 and HEI 4-118599, a stimulable phosphor is formed on an aluminum substrate having a surface formed with an alumite layer. The radiation image conversion panel having a stimulable phosphor formed on a substrate will be referred to as "imaging plate" in the following as the case may be.

### SUMMARY OF THE INVENTION

In the above-mentioned radiation image conversion panel, however, cracks, pinholes, and the like may be formed in the alumite layer by the heat generated when vapor-depositing the scintillator or stimulable phosphor onto the aluminum substrate, for example. As a result, the aluminum substrate and an alkali halide scintillator or stimulable phosphor may react with each other, thereby corroding the aluminum substrate. The corrosion affects resulting images. Even if only a minute point is corroded, the reliability of a captured image utilized for an image analysis will deteriorate. The corrosion may increase as time passes. While the radiation image conversion panel is required to have uniform luminance and resolution characteristics within the substrate surface, the substrate is harder to manufacture as it is larger in size.

In view of the circumstances mentioned above, it is an object of the present invention to provide a radiation image conversion panel, a scintillator panel, and a radiation image sensor which can prevent aluminum substrates from corroding.

For solving the problem mentioned above, the radiation image conversion panel in accordance with the present invention comprises an aluminum substrate, an alumite layer formed on a surface of the aluminum substrate, an intermediate film covering the alumite layer and having a radiation transparency and a light transparency, and a converting part provided on the intermediate film and adapted to convert a radiation image.

The scintillator panel in accordance with the present invention comprises an aluminum substrate, an alumite layer formed on a surface of the aluminum substrate, an intermediate film covering the alumite layer and having a radiation transparency and a light transparency, and a scintillator provided on the intermediate film.

The radiation image sensor in accordance with the present invention comprises a radiation image conversion panel including an aluminum substrate, an alumite layer formed on a surface of the aluminum substrate, an intermediate film covering the alumite layer and having a radiation transparency and a light transparency, and a converting part provided on the intermediate film and adapted to convert a radiation image; and an image pickup device for converting light emitted from the converting part of the radiation image conversion panel into an electric signal.

### BRIEF DESCRIPTION OF THE DRAWINGS

Fig. 1 is a partly broken perspective view schematically showing a scintillator panel in accordance with a first embodiment;
Fig. 2 is a sectional view taken along the line II-II shown in Fig. 1;
Figs. 3A to 3D are process sectional views schematically showing an example of the method of manufacturing a scintillator panel in accordance with the first embodiment;
Fig. 4 is a diagram showing an example of radiation image sensor including the scintillator panel in accordance with the first embodiment;
Fig. 5 is a view showing another example of radiation image sensor including the scintillator panel in accordance with the first embodiment;
Fig. 6 is a sectional view schematically showing the scintillator panel in accordance with a second embodiment; and
Fig. 7 is a sectional view schematically showing the scintillator panel in accordance with a third embodiment.

### DESCRIPTION OF THE PREFERRED EMBODIMENTS

In the following, preferred embodiments of the present invention will be explained in detail with reference to the accompanying drawings. For easier understanding of the explanation, the same constituents in the drawings will be referred to with the same numerals whenever possible while omitting their overlapping descriptions. The dimensions of the drawings include parts exaggerated for explanations and do not always match dimensional ratios in practice.

(First Embodiment)

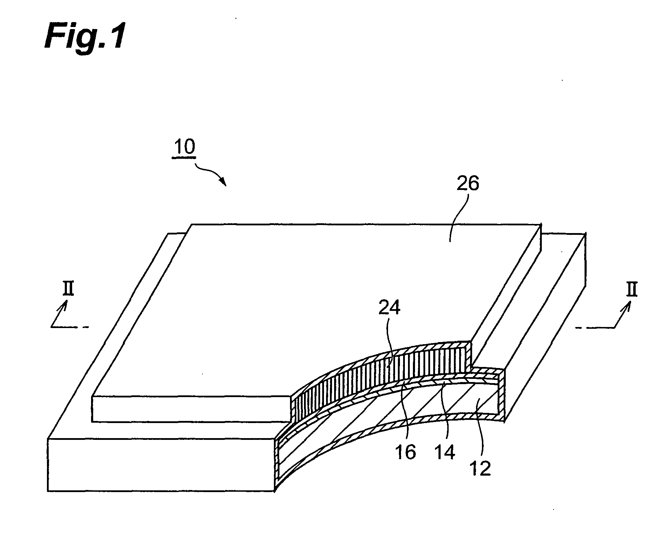

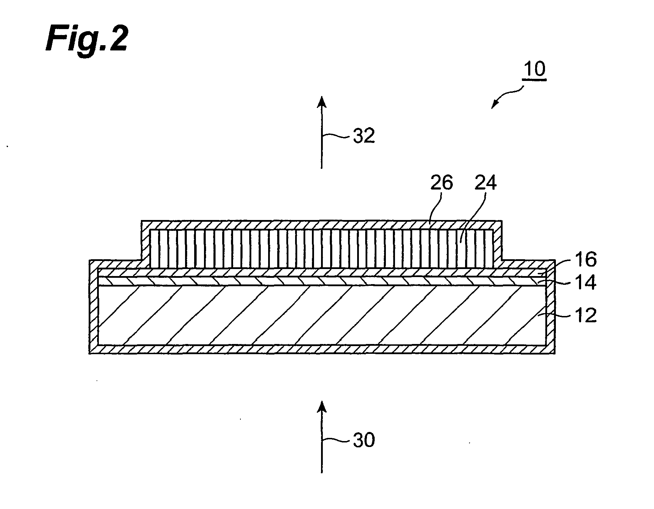

Fig. 1 is a partly broken perspective view showing a scintillator panel (an example of radiation image conversion panel) in accordance with a first embodiment. Fig. 2 is a sectional view taken along the line II-II shown in Fig. 1. As shown in Figs. 1 and 2, the scintillator panel 10 comprises an aluminum substrate 12, an alumite layer 14 formed on a surface of the aluminum substrate 12, and an intermediate film 16 which is provided on the alumite layer 14 and has a radiation transparency. The alumite layer 14 and intermediate film 16 are in close contact with each other. The scintillator panel 10 also has a scintillator 24 (an example of a converting part adapted to convert a radiation image) provided on the intermediate film 16. The intermediate film 16 and scintillator 24 are in close contact with each other.

In this embodiment, the aluminum substrate 12, alumite layer 14, intermediate film 16, and scintillator 24 are totally sealed with a protective film 26.

When a radiation 30 such as x-ray is incident on the scintillator 24 from the aluminum substrate 12 side, light 32 such as visible light is emitted from the scintillator 24. Therefore, when a radiation image is incident on the scintillator panel 10, the scintillator 24 converts the radiation image into a light image. The radiation 30 successively passes through the protective film 26, aluminum substrate 12, alumite layer 14, and intermediate film 16, thereby reaching the scintillator 24. The light 32 emitted from the scintillator 24 is transmitted through the protective film 26 to the outside, while passing through the intermediate film 16, so as to be reflected by the alumite layer 14 and aluminum substrate 12 to the outside. The scintillator panel 10 is used for medical and industrial x-ray imaging and the like.

The aluminum substrate 12 is a substrate mainly made of aluminum, but may contain impurities and the like. Preferably, the thickness of the aluminum substrate 12 is 0.3 to 1.0 mm. When the thickness of the aluminum substrate 12 is less than 0.3 mm, the scintillator 24 tends to be easy to peel off as the aluminum substrate 12 bends. When the thickness of the aluminum substrate 12 exceeds 1.0 mm, the transmittance of the radiation 30 tends to decrease.

Layer 14 is made of porous aluminum oxide formed by anodic oxidation of aluminum (i.e. alumite). The alumite layer 14 makes it harder to damage the aluminum substrate 12. If the aluminum substrate 12 is damaged, the reflectance of the aluminum substrate 12 will be less than a desirable value, whereby no uniform reflectance will be obtained within the surface of the aluminum substrate 12. Whether the aluminum substrate 12 is damaged or not can be inspected visually, for example. The alumite layer 14 may be formed on the aluminum substrate 12 on only one side to be formed with the scintillator 24, on both sides of the aluminum substrate 12, or such as to cover the aluminum substrate 12 as a whole. Forming the alumite layer 14 on both sides of the aluminum substrate 12 can reduce the warpage and flexure of the aluminum substrate 12, and thus can prevent the scintillator 24 from being unevenly vapor-deposited. Forming the alumite layer 14 can also erase streaks occurring when forming the aluminum substrate 12 by rolling. Therefore, even when a reflecting film (a metal film and oxide layer) is formed on the aluminum substrate 12, a uniform reflectance can be obtained within the surface of the aluminum substrate 12 in the reflecting film. Preferably, the thickness of the alumite layer 14 is 10 to 5000 nm. When the thickness of the alumite layer 14 is less than 10 nm, the damage prevention effect of the aluminum substrate 12 tends to decrease. When the thickness of the alumite layer 14 exceeds 5000 nm, the alumite layer 14 tends to peel off in particular in corner parts of the aluminum substrate 12, thereby causing large cracks in the alumite layer 14 and deteriorating the moisture resistance of the alumite layer 14. In one example, the thickness of the alumite layer 14 is 1000 nm. The thickness of the alumite layer 14 is appropriately determined according to the size and thickness of the aluminum substrate 12.

The alumite layer 14 may be colored with a dye or the like, for example. When the alumite layer 14 is not colored, the light 32 is reflected by both of the surface of the alumite layer 14 and the surface of the aluminum substrate 12. Since the light 32 is reflected by the surface of the aluminum substrate 12, the luminance of the scintillator panel 10 improves in this case. When the alumite layer 14 is colored black or the like, for example, on the other hand, the resolution can be enhanced, although the light 32 is absorbed so that the luminance of the scintillator panel 10 decreases. The alumite layer 14 may be provided with a desirable color so as to absorb a predetermined wavelength of light.

The intermediate film 16 and protective film 26 are organic or inorganic films, which may be made of materials different from each other or the same material. The intermediate film 16 and protective film 26 are made of polyparaxylylene, for example, but may also be of xylylene-based materials such as polymonochloroparaxylylene, polydichloroparaxylylene, polytetrachloroparaxylylene, polyfluoroparaxylylene, polydimethylparaxylylene, and polydiethylparaxylylene. The intermediate film 16 and protective film 26 may be made of polyurea, polyimide, and the like, for example, or inorganic materials such as LiF, MgF₂, SiO₂, Al₂O₃, TiO₂, MgO, and SiN. The intermediate film 16 and protective film 26 may also be formed by combining inorganic and organic films. In one example, the intermediate film 16 and protective film 26 have a thickness of 10 µm each. The intermediate film 16 reduces minute irregularities of the alumite layer 14, thereby advantageously acting for forming the scintillator 24 having a uniform thickness on the alumite layer 14.

The scintillator 24 is smaller than the aluminum substrate 12 when seen in the thickness direction of the aluminum substrate 12. For example, the scintillator 24 is constituted by a phosphor which converts the radiation into visible light and is made of a columnar crystal or the like of CsI doped with Tl, Na, or the like. The scintillator 24 has a structure provided with a forest of columnar crystals. The scintillator 24 may also be made of Tl-doped NaI, Tl-doped KI, or Eu-doped LiI. A stimulable phosphor such as Eu-doped CsBr may be used in place of the scintillator 24. The thickness of the scintillator 24 is preferably 100 to 1000 µm, more preferably 450 to 550 µm. Preferably, the average column diameter of the columnar crystals constituting the scintillator 24 is 3 to 10 µm.

As explained in the foregoing, the scintillator panel 10 comprises the aluminum substrate 12, the alumite layer 14 formed on the surface of the aluminum substrate 12, the intermediate film 16 covering the alumite layer 14 and having a radiation transparency and a light transparency, and the scintillator 24 provided on the intermediate film 16. Since the intermediate film 16 is provided between the alumite layer 14 and scintillator 24, the scintillator panel 10 can keep the alumite layer 14 and scintillator 24 from reacting with each other even if the alumite layer 14 is formed with cracks, pinholes, and the like. This can prevent the aluminum substrate 12 from corroding. Forming the alumite layer 14 can erase damages to the surface of the aluminum substrate 12, whereby uniform luminance and resolution characteristics can be obtained within the surface of the scintillator panel 10. Further, the intermediate film 16 can improve the flatness of the scintillator 24. The light 32 emitted from the scintillator 24 passes through the intermediate film 16, so as to be mainly reflected by the alumite layer 14 and aluminum substrate 12. Therefore, the wavelength and the like of the light 32 taken out from the scintillator panel 10 can be controlled by adjusting optical characteristics of the alumite layer 14. For example, the wavelength of the light 32 taken out from the scintillator panel 10 can be selected by coloring the alumite layer 14.

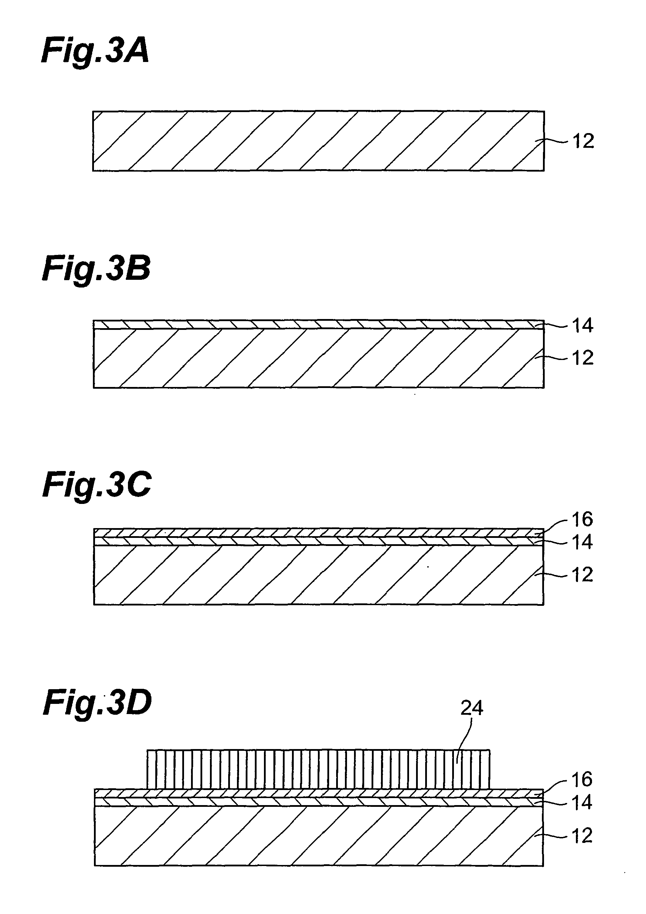

Figs. 3A to 3D are process sectional views schematically showing an example of method of manufacturing the scintillator panel in accordance with the first embodiment. The method of manufacturing the scintillator panel 10 will now be explained with reference to Figs. 3A to 3D.

First, as shown in Fig. 3A, the aluminum substrate 12 is prepared. Subsequently, as shown in Fig. 3B, the alumite layer 14 is formed by anodic oxidation on a surface of the aluminum substrate 12. For example, the aluminum substrate 12 is electrolyzed by an anode in an electrolyte such as dilute sulfuric acid, so as to be oxidized. This forms the alumite layer 14 constituted by an assembly of hexagonal columnar cells each having a fine hole at the center. The alumite layer 14 may be dipped in a dye, so as to be colored. This can improve the resolution or enhance the luminance. After being formed, the alumite layer 14 is subjected to a sealing process for filling the fine holes.

Next, as shown in Fig. 3C, the intermediate film 16 is formed on the alumite layer 14 by using CVD. Further, as shown in Fig. 3D, the scintillator 24 is formed on the intermediate film 16 by using vapor deposition. Subsequently, the protective film 26 is formed by using CVD so as to seal the aluminum substrate 12, alumite layer 14, intermediate film 16, and scintillator 24 as a whole. Thus, the scintillator panel 10 is manufactured. The sealing with the protective film 26 can be realized by lifting the side of the aluminum substrate 12 opposite from the scintillator forming surface from a substrate holder at the time of CVD. An example of such method is one disclosed in U.S. Patent No. 6,777,690. This method lifts the aluminum substrate 12 by using pins. In this case, no protective film is formed on minute contact surfaces between the aluminum substrate 12 and the pins.

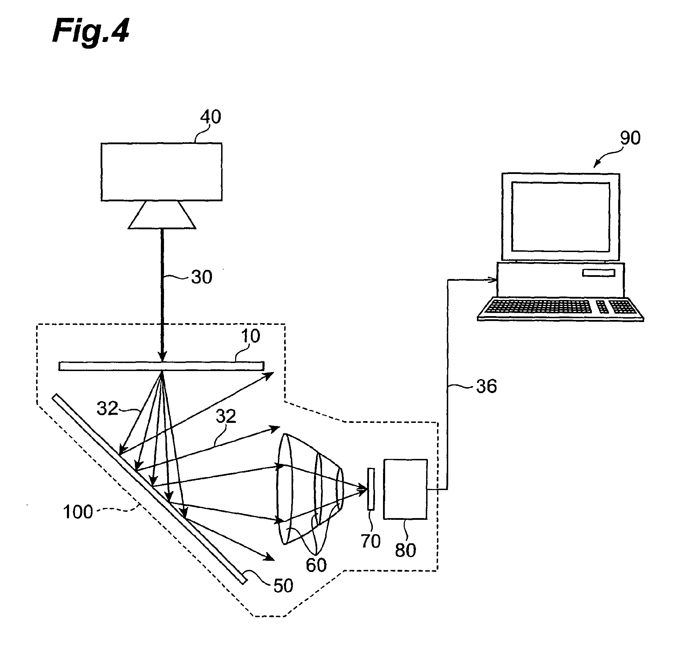

Fig. 4 is a diagram showing an example of radiation image sensor including the scintillator panel in accordance with the first embodiment. The radiation image sensor 100 shown in Fig. 4 comprises the scintillator panel 10 and an image pickup device 70 which converts the light 32 emitted from the scintillator 24 of the scintillator panel 10 into an electric signal. The light 32 emitted from the scintillator 24 is reflected by a mirror 50, so as to be made incident on a lens 60. The light 32 is converged by the lens 60, so as to be made incident on the image pickup device 70. One or a plurality of lenses 60 may be provided.

The radiation 30 emitted from a radiation source 40 such as x-ray source is transmitted through an object to be inspected which is not depicted. The transmitted radiation image is made incident on the scintillator 24 of the scintillator panel 10. As a consequence, the scintillator 24 emits a visible light image (the light 32 having a wavelength to which the image pickup device 70 is sensitive) corresponding to the radiation image. The light 32 emitted from the scintillator 24 is made incident on the image pickup device 70 by way of the mirror 50 and lens 60. For example, CCDs, flat panel image sensors, and the like can be used as the image pickup device 70. Thereafter, an electronic device 80 receives the electric signal from the image pickup device 70, whereby the electric signal is transmitted to a workstation 90 through a lead 36. The workstation 90 analyzes the electric signal, and outputs an image onto a display.

The radiation image sensor 100 comprises the scintillator panel 10 and the image pickup device 70 adapted to convert the light 32 emitted from the scintillator 24 of the scintillator panel 10 into the electric signal. Therefore, the radiation image sensor 100 can prevent the aluminum substrate 12 from corroding.

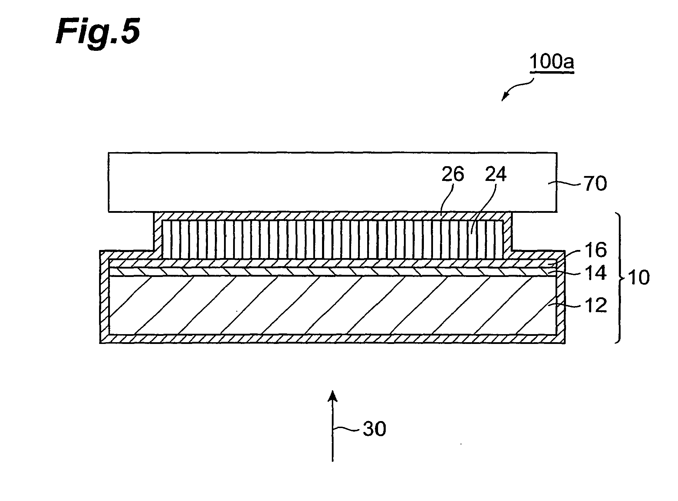

Fig. 5 is a view showing another example of radiation image sensor including the scintillator panel in accordance with the first embodiment. The radiation image sensor 100a shown in Fig. 5 comprises the scintillator panel 10, and an image pickup device 70 which is arranged so as to oppose the scintillator panel 10 and adapted to convert light emitted from the scintillator 24 into an electric signal. The scintillator 24 is arranged between the aluminum substrate 12 and image pickup device 70. The light-receiving surface of the image pickup device 70 is arranged on the scintillator 24 side. The scintillator panel 10 and image pickup device 70 may be joined together or separated from each other. When joining them, an adhesive may be used, or an optical coupling material (refractive index matching material) may be utilized so as to reduce the loss of the emitted light 32 in view of the refractive indexes of the scintillator 24 and protective film 26.

The radiation image sensor 100a comprises the scintillator panel 10 and the image pickup device 70 adapted to convert the light 32 emitted from the scintillator 24 of the scintillator panel 10 into the electric signal. Therefore, the radiation image sensor 100a can prevent the aluminum substrate 12 from corroding.

(Second Embodiment)

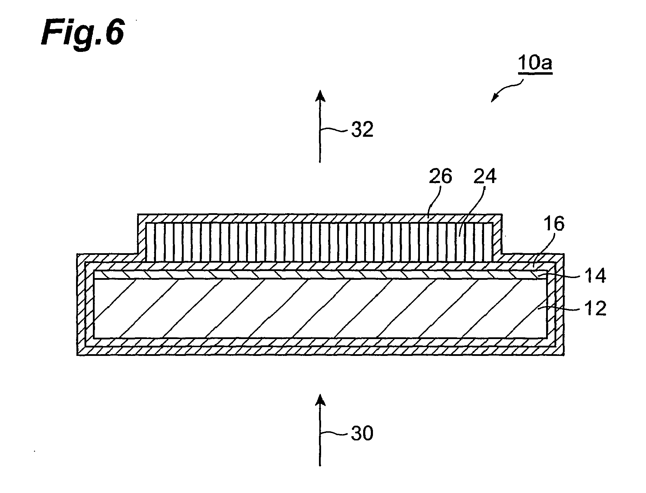

Fig. 6 is a sectional view schematically showing the scintillator panel in accordance with a second embodiment. The scintillator panel 10a shown in Fig. 6 has the same structure as that of the scintillator panel 10 except that the intermediate film 16 totally seals the aluminum substrate 12 and alumite layer 14. Therefore, the scintillator panel 10a not only exhibits the same operations and effects as those of the scintillator 10, but further improves the moisture resistance of the aluminum substrate 12, and thus can more reliably prevent the aluminum substrate 12 from corroding.

(Third Embodiment)

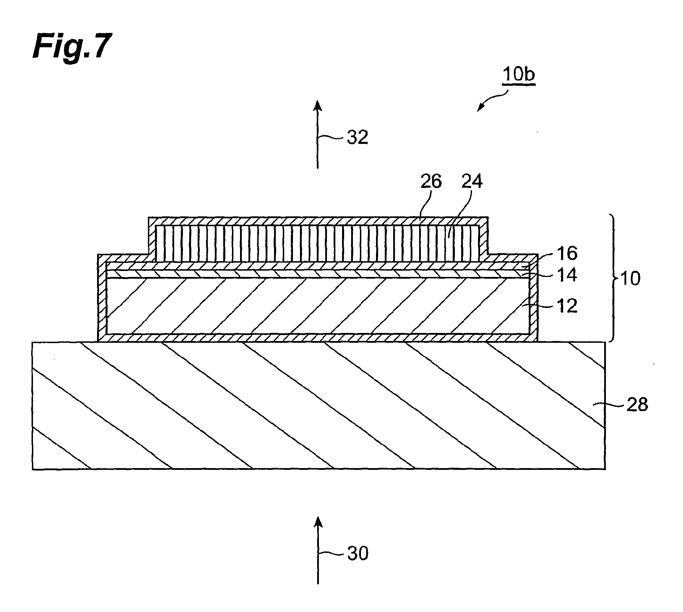

Fig. 7 is a sectional view schematically showing the scintillator panel in accordance with a third embodiment. The scintillator panel 10b shown in Fig. 7 further comprises a radiation-transparent reinforcement plate 28 bonded to the aluminum substrate 12 in addition to the structure of the scintillator panel 10. The aluminum substrate 12 is arranged between the reinforcement plate 28 and scintillator 24.

The reinforcement plate 28 is bonded to the aluminum substrate 12 by a double-sided adhesive tape, an adhesive, or the like, for example. Employable as the reinforcement plate 28 are (1) carbon fiber reinforced plastics (CFRP), (2) carbon boards (made by carbonizing and solidifying charcoal and paper), (3) carbon substrates (graphite substrates), (4) plastic substrates, (5) sandwiches of thinly formed substrates (1) to (4) mentioned above with resin foam, and the like. Preferably, the thickness of the reinforcement plate 28 is greater than the total thickness of the aluminum substrate 12 and alumite layer 14. This improves the strength of the scintillator panel 10b as a whole.
Preferably, the reinforcement plate 28 is larger than the scintillator 24 when seen in the thickness direction of the aluminum substrate 12. Namely, it will be preferred if the reinforcement plate 28 hides the scintillator 24 when seen in the thickness direction of the aluminum substrate 12 from the reinforcement plate 28 side. This can prevent a shadow of the reinforcement plate 28 from being projected. In particular, this can prevent an image from becoming uneven because of the shadow of the reinforcement plate 28 when the radiation image 30 having a low energy is used.

The scintillator 10b not only exhibits the same operations and effects as those of the scintillator panel 10, but can further improve the flatness and rigidity of the scintillator panel 10b. Therefore, the scintillator panel 10b can prevent the scintillator 24 from peeling off as the aluminum substrate 12 bends. Since the radiation image sensor 100 shown in Fig. 4 uses the scintillator panel as a single unit, it is effective to employ the scintillator panel 10b having a high rigidity.

The reinforcement plate 28 may be bonded to the scintillator panel 10a instead of the scintillator panel 10.

Though preferred embodiments of the present invention are explained in detail in the foregoing, the present invention is not limited to the above-mentioned embodiments and the structures exhibiting various operations and effects mentioned above.

For example, the radiation image sensors 100, 100a may employ one of the scintillator panels 10a, 10b in place of the scintillator panel 10.

The scintillator panels 10, 10a, 10b may be free of the protective film 26.

Though the above-mentioned embodiments exemplify the radiation image conversion panel by the scintillator panel, a stimulable phosphor (an example of a converting part adapted to convert a radiation image) may be used in place of the scintillator 24, whereby an imaging plate as the radiation image conversion panel can be made. The stimulable phosphor converts the radiation image into a latent image. This latent image is scanned with laser light, so as to read a visible light image. The visible light image is detected by a detector (photosensor such as line sensor, image sensor, and photomultiplier).

## Claims

1. A radiation image conversion panel comprising:
an aluminum substrate;
an aluminum oxide layer formed on a surface of the aluminum substrate;
an intermediate film covering the aluminum oxide layer and having a radiation transparency and a light transparency; and
a converting part provided on the intermediate film and adapted to convert a radiation image.

2. A scintillator panel comprising:
an aluminum substrate;
an aluminum oxide layer formed on a surface of the aluminum substrate;
an intermediate film covering the aluminum oxide layer and having a radiation transparency and a light transparency; and
a scintillator provided on the intermediate film.

3. A scintillator panel according to claim 2, further comprising a radiation-transparent reinforcement plate bonded to the aluminum substrate, the aluminum substrate being arranged between the reinforcement plate and the scintillator.

4. A radiation image sensor including:
a radiation image conversion panel comprising an aluminum substrate, an aluminum oxide layer formed on a surface of the aluminum substrate, an intermediate film covering the aluminum oxide layer and having a radiation transparency and a light transparency, and a converting part provided on the intermediate film and adapted to convert a radiation image; and
an image pickup device for converting light emitted from the converting part of the radiation image conversion panel into an electric signal.
